# EUROPÄISCHE PATENTSCHRIFT

(11) **EP 0 864 172 B1**
(45) Veröffentlichungstag und Bekanntmachung des Hinweises auf die Patenterteilung: **04.10.2001**
(21) Anmeldenummer: 96945866.0
(22) Anmeldetag: 07.11.1996
(51) Int. Cl.: H01L 21/28, H01L 21/336

(54) **VERFAHREN ZUR HERSTELLUNG EINER INTEGRIERTEN SCHALTUNGSANORDNUNG MIT MINDESTENS EINEM MOS-TRANSISTOR**
PROCESS FOR PRODUCING AN INTEGRATED CIRCUIT DEVICE WITH AT LEAST ONE MOS TRANSISTOR
PROCEDE DE FABRICATION D'UN DISPOSITIF A CIRCUITS INTEGRES EQUIPE D'AU MOINS UN TRANSISTOR MOS

(30) Priorität: 30.11.1995 DE 19544721
(43) Veröffentlichungstag der Anmeldung: 16.09.1998
(73) Patentinhaber: Infineon Technologies AG, 81669 München (DE)
(72) Erfinder: SCHWALKE, Udo, D-84431 Heldenstein (DE)
(74) Vertreter: Zedlitz, Peter, Dipl.-Inf.
(86) Internationale Anmeldenummer: DE9602121
(87) Internationale Veröffentlichungsnummer: WO9720336

(56) Entgegenhaltungen:
- EP-A- 0 115 131
- EP-A- 0 373 893
- EP-A- 0 442 296
- US-A- 5 144 390
- US-A- 5 177 028
- US-A- 5 294 823

## Beschreibung

Zur Entwicklung integrierter Schaltungsanordnungen mit MOS-Transistoren, die bei Betriebsspannungen unter 3 Volt betrieben werden können und die einen verringerten Leistungsverbrauch aufweisen, werden derzeit verschiedene Konzepte verfolgt. Eines dieser Konzepte sieht vor, anstelle der üblicherweise verwendeten monokristallinen Siliziumscheibe als Substrat ein SOI-Substrat vorzusehen, das eine monokristalline Siliziumschicht, eine darunter angeordnete isolierende Schicht und eine darunter angeordnete Trägerscheibe umfaßt.

MOS-Transistoren werden in der monokristallinen Siliziumschicht des SOI-Substrats realisiert. Dabei wird das aktive Gebiet eines MOS-Transistors gegenüber benachbarten Bauelementen durch Wegätzen des umgebenden Siliziums galvanisch vollständig isoliert. Damit werden parasitäre Effekte wie zum Beispiel Latch-up vollständig unterbunden.

MOS-Schaltungen auf einem SOI-Substrat weisen bei gleicher Schaltgeschwindigkeit einen deutlich geringeren Leistungsverbrauch auf als die entsprechende Schaltung in einer monokristallinen Siliziumscheibe.

Zur lateralen Isolierung des aktiven Gebietes eines MOS-Transistors in einem SOI-Substrat ist eine MESA-Ätzung der monokristallinen Siliziumschicht vorgeschlagen worden (siehe zum Beispiel Silicon-on-Insulator Technology, Jean Pierre Colinge, Kluwer Academic 1991, Seiten 94 bis 98). In vertikaler Richtung ist das aktive Gebiet des MOS-Transistors durch die darunter angeordnete isolierende Schicht isoliert. Zur Realisierung des MOS-Transistors wird die Oberfläche der MESAStruktur mit einem Gateoxid versehen. Darauf wird zum Beispiel aus Polysilizium eine Gateelektrode aufgebracht. Zur Kontaktierung mit einer Gateleitung verläuft die Gateelektrode teilweise über die Seitenwand des MESA. Das bedingt eine Gate-Seitenwandsteuerung, die den unerwünschten, sogenannten "corner-effect" verursacht. Dieser führt zu nicht idealen Unterschwellenkennlinien. Ferner entstehen bei der thermischen Oxidation zur Bildung des Gatedielektrikums Oxiddünnungen an den Siliziumkanten der Mesastruktur. Diese können zu einem frühzeitigen Oxiddurchbruch führen.

Zur Vermeidung der Seitenwandeffekte ist in J. H. Choi et al, IEDM'94, Seite 645, vorgeschlagen worden, zur lateralen Isolierung des aktiven Gebietes eine modifizierte LOCOS-Isolation vorzusehen. Bei dem LOCOS-Verfahren treten mechanische Spannungen in der monokristallinen Siliziumschicht auf. Ferner ist die Schichtkonformität nicht gewährleistet. Schließlich ist die Skalierbarkeit des LOCOS-Prozeß auf Strukturgrößen unter 0,25 um schwierig. Damit ist die erzielbare Packungsdichte begrenzt.

Von P. V. Gilbert et al, VLSI'95, Seite 37, ist zwar ein modifizierter LOCOS-Prozeß für Dünnfilm-SOI-Technologie vorgeschlagen worden, mit dem Strukturgrößen unter 0,5 um erzielbar sind. Der Prozeß ist jedoch aufwendig, da er zusätzliche Schichtabscheidungen und Ätzschritte erfordert.

Ferner führen LOCOS-Prozesse zur Ausbildung eines sogenannten Vogelschnabels, der die Schichtdicke der monokristallinen Siliziumschicht des SOI-Substrates herabsetzt. Bei dünnen Schichtdicken, wie dies für Hochgeschwindigkeits-MOS-Transistoren empfehlenswert ist, führt dies zusätzlich zu einer Widerstandserhöhung beim Source/Drain-Kontakt. In J. M. Hwang et al, VLSI'94, Seite 33, ist vorgeschlagen worden, derartige unerwünschte, aber nicht vermeidbare Dünnungen der Siliziumschicht des SOI-Substrats durch selektives Aufwachsen von Silizium zu kompensieren.

Der Erfindung liegt das Problem zugrunde, ein Verfahren zur Herstellung einer integrierten Schaltungsanordnung mit mehr als einem MOS-Transistor anzugeben, mit dem eine hohe Pakkungsdichte von MOS-Transistoren erzielbar ist, ohne daß diese eine Gateseitenwandsteuerung oder einen Oxiddurchbruch an Gateoxidkanten zeigen.

Dieses Problem wird erfindungsgemäß gelöst durch ein Verfahren gemäß Anspruch 1. Weitere Ausgestaltungen der Erfindung gehen aus den übrigen Ansprüchen hervor.

In dem erfindungsgemäßen Verfahren werden auf die monokristalline Siliziumschicht eines SOI-Substrats zunächst ein Gatedielektrikum und eine erste Elektrodenschicht aufgebracht, die zusammen mit der monokristallinen Siliziumschicht des SOI-Substrats strukturiert werden. Dabei entsteht eine Mehrschichtstruktur, um die herum die Oberfläche der isolierenden Schicht des SOI-Substrats freigelegt ist. An den Flanken der Mehrschichtstruktur werden isolierende Spacer gebildet. In einem weiteren Strukturierungsschritt wird die erste Elektrodenschicht im Bereich der Mehrschichtstruktur so strukturiert, daß eine Gateelektrode entsteht. Die isolierenden Spacer an den Flanken der Mehrschichtstruktur verhindern einerseits eine Gateseitenwandsteuerung, andererseits verhindern sie Oxiddünnungen an den Kanten der strukturierten monokristallinen Siliziumschicht und damit einen frühzeitigen Oxiddurchbruch an der Gateoxidkante. Das Gatedielektrikum ist nur an der Oberfläche der monokristallinen Siliziumschicht und nicht an deren Flanken angeordnet.

Es ist vorteilhaft, nach der Bildung der isolierenden Spacer an den Flanken der Mehrschichtstruktur ganzflächig eine zweite Elektrodenschicht aufzubringen. Die zweite Elektrodenschicht wird bei der Bildung der Gateelektrode gleichzeitig strukturiert. Bei der Strukturierung der zweiten Elektrodenschicht können gleichzeitig über die Mehrschichtstruktur hinausragende leitende Verbindungen für die Gateelektrode, zum Beispiel eine Gateleitungsebene, gebildet werden.

Zwischen der ersten Elektrodenschicht und der zweiten Elektrodenschicht können weitere Schichten vorgesehen sein, zum Beispiel zur Bildung eines floatenden Gates. Diese weiteren Schichten können bei der ersten Strukturierung zur Bildung der Mehrschichtstruktur oder bei der zweiten Strukturierung zur Bildung der Gateelektrode mit strukturiert werden.

Die Source/Drain-Gebiete des MOS-Transistors werden im Bereich der Mehrschichtstruktur in der monokristallinen Siliziumschicht seitlich der Gateelektrode gebildet. Da bei der Strukturierung der Gateelektrode der isolierende Spacer, der an den Flanken der Mehrschichtstruktur gebildet wurde, im wesentlichen nicht angegriffen wird, entsteht zwischen Spacer und Gateelektrode eine Vertiefung. Es liegt im Rahmen der Erfindung, die Flanken der Gateelektrode mit isolierenden Spacern zu versehen und die Vertiefung durch selektive Epitaxie von Silizium aufzufüllen. Die Source/Drain-Gebiete werden dann in dem epitaktisch aufgewachsenen Silizium und der darunterliegenden monokristallinen Siliziumschicht gebildet. Dieses hat den Vorteil, daß der MOS-Transistor eine im wesentlichen planare Oberfläche aufweist. Bei Verwendung eines SOI-Substrats mit einer monokristallinen Siliziumschicht mit einer Schichtdicke im Bereich von 20 bis 100 nm, wie es für Hochgeschwindigkeits-MOS-Transistoren im Hinblick auf ein vollständig entleertes (fully depleted) Kanalgebiet vorteilhaft ist, hat diese Maßnahme darüber hinaus den Vorteil, daß in den Source/Drain-Gebieten mehr Silizium zur Verfügung steht. Dieses epitaktische Auffüllen der Vertiefung ist insbesondere bei der Bildung von Metallsilizid an der Oberfläche der Source/Drain-Gebiete vorteilhaft, da bei der Silizidbildung ein Siliziumverbrauch auftritt und auf diese Weise verhindert wird, daß das gesamte Source/Drain-Gebiet bei der Metallsilizidbildung verbraucht wird.

Es liegt im Rahmen der Erfindung, aus der ersten Elektrodenschicht, dem Gatedielektrikum und der monokristallinen Siliziumschicht beim ersten Strukturierungsschritt gleichzeitig eine Vielzahl Mehrschichtstrukturen für eine Vielzahl MOS-Transistoren zu bilden.

Sollen die Gateelektroden verschiedener MOS-Transistoren unterschiedlich dotiert werden, erfolgt die Dotierung nach der Bildung der Mehrschichtstrukturen zum Beispiel durch maskierte Implantation. Die Dotierung der Gateelektroden kann sich dabei sowohl in Bezug auf die Dotierstoffkonzentration als auch in Bezug auf den Leitfähigkeitstyp unterscheiden. Insbesondere bei der Herstellung von komplementären MOS-Transistoren mit n⁺-dotierten und p⁺-dotierten Gateelektroden ist das Verfahren vorteilhaft einsetzbar, da durch die Dotierung nach der Bildung der Mehrschichtstrukturen eine laterale Diffusion von Dotierstoff zwischen n⁺-dotierten Gateelektroden und p⁺-dotierten Gateelektroden wirksam unterdrückt wird.

Eine Gateleitungsebene zur Verbindung der verschiedenen Gateelektroden wird in diesem Fall vorzugsweise bei der Strukturierung der zweiten Elektrodenschicht realisiert.

Nach der Bildung der Mehrschichtstrukturen können die Zwischenräume zwischen benachbarten Mehrschichtstrukturen mit isolierendem Material aufgefüllt werden. Das hat den Vorteil, daß die zweite Elektrodenschicht auf eine planarisierte Oberfläche aufgebracht wird.

Im folgenden wird die Erfindung anhand eines Ausführungsbeispiels und der Figuren näher erläutert.
- Figur 1: zeigt ein SOI-Substrat mit einem Gatedielektrikum, einer ersten Elektrodenschicht und einer Photolackmaske.
- Figur 2: zeigt das SOI-Substrat nach Bildung einer Mehrschichtstruktur und Bildung von ersten isolierenden Spacern an den Flanken der Mehrschichtstrukturen.
- Figur 3: zeigt eine Aufsicht auf Figur 2.
- Figur 4: zeigt einen Schnitt durch das SOI-Substrat nach Abscheidung einer zweiten Elektrodenschicht, einer Deckschicht und Bildung einer Photolackmaske.
- Figur 5: zeigt das SOI-Substrat nach der Bildung von Gateelektroden.
- Figur 6: zeigt eine Aufsicht auf die Struktur von Figur 5.
- Figur 7: zeigt einen Schnitt durch das SOI-Substrat nach der Bildung von zweiten isolierenden Spacern an den Flanken der Gateelektroden, der in Figur 6 mit VII-VII bezeichnet ist.
- Figur 8: zeigt einen Schnitt durch das SOI-Substrat nach Abscheidung von Silizium durch selektive Epitaxie und nach Bildung von Source/Drain-Gebieten, dere in Figur 6 mit VIII-VIII bezeichnet ist.
- Figur 9: zeigt den in Figur 6 mit IX-IX bezeichneten Schnitt durch das SOI-Substrat.

Ein SOI-Substrat umfaßt einen Träger 1, eine isolierende Schicht 2 und eine monokristalline Siliziumschicht 3. Der Träger 1 besteht zum Beispiel aus einer monokristallinen Siliziumscheibe. Die isolierende Schicht 2 besteht zum Beispiel aus SiO₂ und weist eine Dicke von zum Beispiel 400 nm auf. Die monokristalline Siliziumschicht 3 ist zum Beispiel n-dotiert und weist eine Dicke von zum Beispiel 60 nm auf.

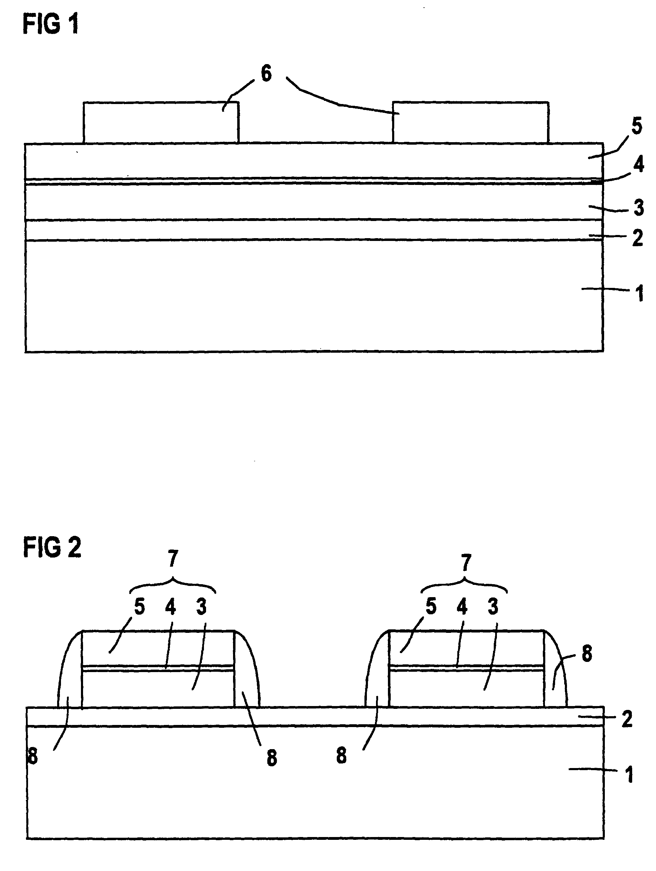

Auf die monokristalline Siliziumschicht 3 wird ein Gatedielektrikum 4 aufgebracht. Das Gatedielektrikum 4 wird zum Beispiel durch thermische Oxidation aus SiO₂ mit einer Schichtdicke von zum Beispiel 6 nm gebildet (siehe Figur 1).

Auf das Gatedielektrikum 4 wird eine erste Elektrodenschicht 5 abgeschieden. Die erste Elektrodenschicht 5 wird zum Beispiel aus undotiertem oder dotiertem Silizium, das amorph oder polykristallin ist, in einer Schichtdicke von 200 nm abgeschieden.

Auf der Oberfläche der ersten Elektrodenschicht 5 wird eine Photolackmaske 6 gebildet, die die Anordnung von aktiven Gebieten für MOS-Transistoren in der monokristallinen Siliziumschicht 3 definiert.

Unter Verwendung eines mehrstufigen, anisotropen Ätzprozesses, zum Beispiel mit CHF₃/O₂ und BCl₃/HCl werden die erste Elektrodenschicht 5, das Gatedielektrikum 4 und die monokristalline Siliziumschicht 3 strukturiert. Dabei entstehen Mehrschichtstrukturen 7, die jeweils das aktive Gebiet für einen MOS-Transistor umfassen (siehe Figur 2). Durch ganzflächiges Abscheiden einer dielektrischen Schicht mit im wesentlichen konformer Kantenbedeckung und anisotropes Rückätzen der dielektrischen Schicht werden an den Flanken der Mehrschichtstrukturen erste isolierende Spacer 8 gebildet. Die ersten isolierenden Spacer 8 werden zum Beispiel aus SiO₂ oder Si₃N₄ gebildet.

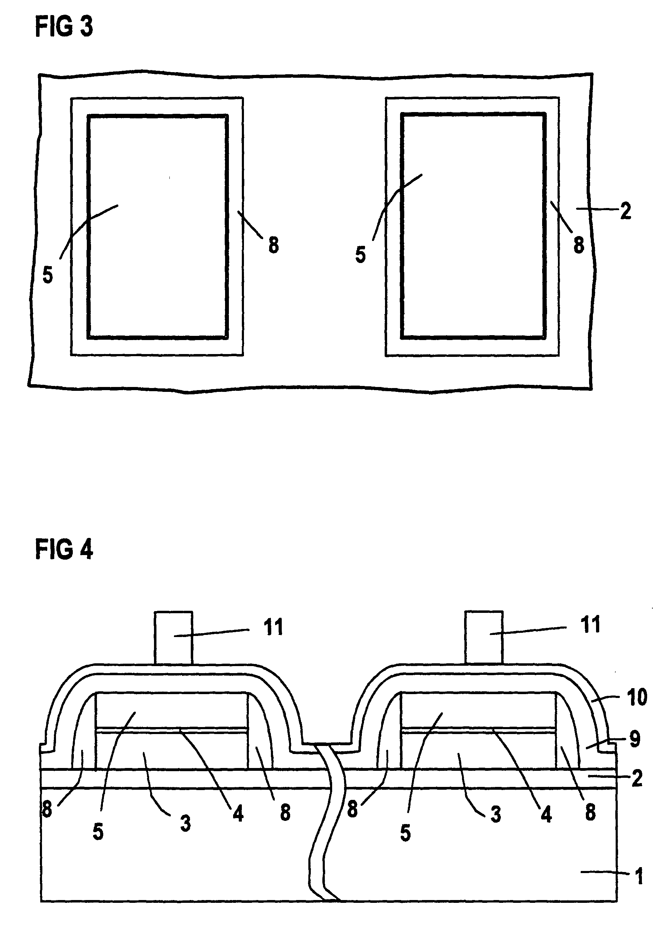

Die ersten isolierenden Spacer 8 umgeben die Mehrschichtstruktur 7 jeweils ringförmig (siehe Aufsicht in Figur 3). Jede Mehrschichtstruktur 7 ist gegen den Träger 1 durch die isolierende Schicht 2 und gegenüber benachbarten Mehrschichtstrukturen 7 durch die ersten isolierenden Spacer 8 isoliert. Außerhalb der ersten isolierenden Spacer 8 liegt die Oberfläche der isolierenden Schicht 2 frei.

Anschließend wird die strukturierte erste Elektrodenschicht 5 dotiert, falls sie undotiert abgeschieden wurde. Dieses erfolgt zum Beispiel durch Implantation mit Arsen (5x 10¹⁵cm⁻², 50 keV) oder durch Belegung aus der Gasphase.

Es wird ganzflächig eine zweite Elektrodenschicht 9 abgeschieden. Die zweite Elektrodenschicht 9 wird zum Beispiel aus dotiertem, amorphem oder polykristallinem Silizium, Metallsilizid, Metall wie zum Beispiel TiN oder W oder aus Kombinationen aus diesen Materialien gebildet. Sie wird in einer Schichtdicke von zum Beispiel 50 bis 200 nm abgeschieden (siehe Figur 4).

Auf die zweite Elektrodenschicht wird eine Deckschicht 10 aus zum Beispiel TEOS abgeschieden. Die Deckschicht 10 wird in einer Dicke von zum Beispiel 20 nm gebildet.

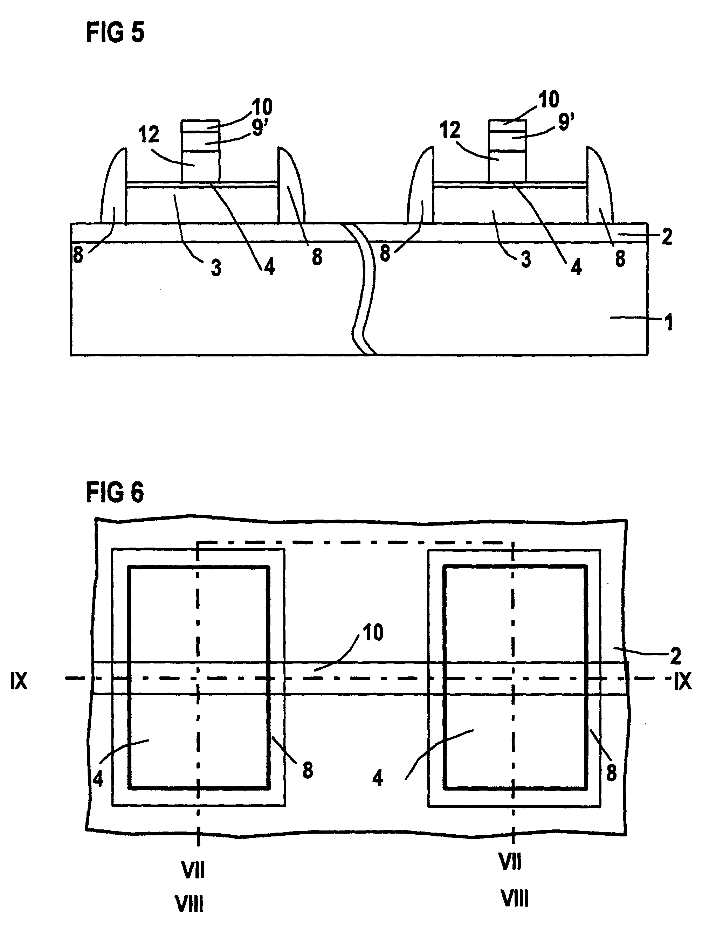

Mit Hilfe einer Photolackmaske 11 werden die Deckschicht 10, die zweite Elektrodenschicht 9 und die strukturierte erste Elektrodenschicht 5 strukturiert (siehe Figur 5). Dieses erfolgt mittels mehrstufiger anisotroper Ätzung zum Beispiel mit CHF₃/O₂ und BCL₃/HCl. Dabei werden aus der ersten Elektrodenschicht 5 Gateelektroden 12 gebildet. Aus der zweiten Elektrodenschicht 9 werden Gateleitungen 9' gebildet, die die Gateelektroden 12 miteinander verbinden (siehe Aufsicht in Figur 6). Die Gateleitungen 9' sind im Bereich der aktiven Gebiete selbstjustiert mit den Gateelektroden 12 verbunden.

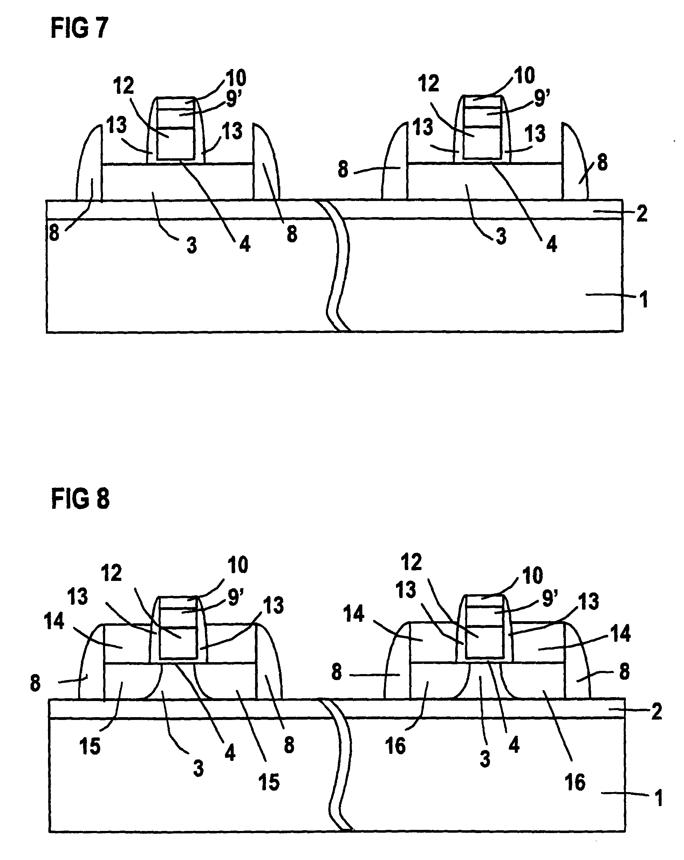

An den Flanken der Gateelektroden 12 und der Deckschicht 10 werden zweite isolierende Spacer 13 durch konformes Abscheiden und anschließendes anisotropes Rückätzen von TEOS-SiO₂ oder Si₃N₄ gebildet. Bei der Spacerätzung wird seitlich der Gateelektrode 12 das Gatedielektrikum 4 entfernt und die Oberfläche der monokristallinen Siliziumschicht 3 in den aktiven Gebieten freigelegt (siehe Figur 7).

Durch selektive Epitaxie wird auf der freiliegenden Oberfläche der monokristallinen Siliziumschicht 3 ein Siliziumgebiet 14 aufgewachsen. Die selektive Epitaxie erfolgt zum Beispiel mit SiHCl₃. Das Siliziumgebiet 14 wird vorzugsweise in einer solchen Dicke aufgewachsen, daß es in der Höhe mit den ersten isolierenden Spacern 8 abschließt (siehe Figur 8).

Anschließend werden in bekannter Weise durch Ionenimplantation, Phototechnik (nicht im einzelnen dargestellt) und Temperung n⁺-dotierte Source/Drain-Gebiete 15 und p⁺-dotierte Source/Drain-Gebiete 16 für NMOS-Transistoren bzw. PMOS-Transistoren hergestellt. Die Source/Drain-Gebiete 15, 16 erstrecken sich jeweils sowohl in dem Siliziumgebiet 14 als auch in dem darunterliegenden Anteil der monokristallinen Siliziumschicht 3.

Zur Fertigstellung der Schaltungsanordnung wird anschließend eine Passivierungsschicht zum Beispiel aus BPSG abgeschieden und planarisiert. Es werden Kontaktlöcher zu den Source/Drain-Gebieten 15, 16 und den Gateelektroden 12 geätzt und mit Metallisierungen versehen. Diese Prozeßschritte sind nicht im einzelnen dargestellt.

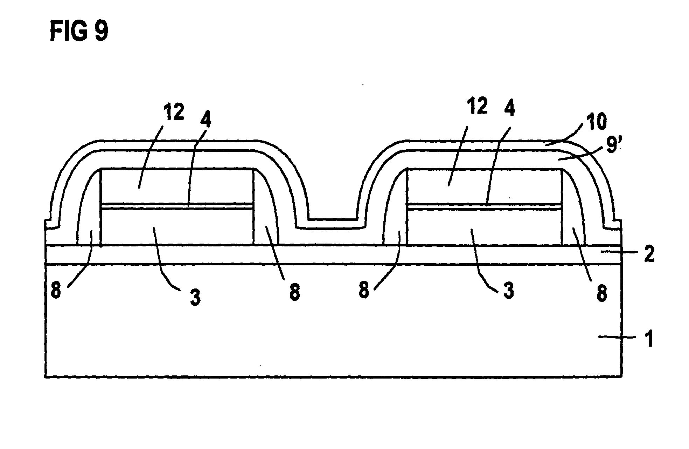

Aus der zweiten Elektrodenschicht 9 werden Gateleitungen 9' gebildet. Die Gateleitungen 9' verlaufen über die ersten Spacer 8 und die freigelegte Oberfläche der isolierenden Schicht 2 außerhalb der aktiven Gebiete für die MOS-Transistoren. Da die Oberfläche der monokristallinen Siliziumschicht 3 mit den ersten isolierenden Spacern 8 bedeckt ist, wird auf diese Weise eine Seitenwandsteuerung der MOS-Transistoren durch die zweite Elektrodenschicht 9 verhindert. Dünnungen des Gatedielektrikums 4 an den Kanten der aktiven Gebiete für die MOS-Transistoren, die zu frühzeitigen Oxiddurchbrüchen führen könnten, werden durch die ersten isolierenden Spacer 8 an den Flanken der aktiven Transistorstrukturen ebenfalls wirksam verhindert (siehe Figur 9).

Alternativ kann nach der Bildung der ersten Spacer 8 durch Abscheiden und Rückätzen einer isolierenden Schicht zum Beispiel aus SiO₂ der Zwischenraum zwischen benachbarten Mehrschichtstrukturen 7 mit isolierendem Material aufgefüllt werden. Beim Rückätzen wird die Oberfläche der ersten Elektrodenschicht 5 freigelegt und die Struktur planarisiert. Die zweite Elektrodenschicht 9 wird danach abgeschieden. Die Gateleitungen 9' verlaufen in diesem Fall über die Oberfläche des aufgefüllten isolierenden Materials.

Das erfindungsgemäße Verfahren kann dadurch variiert werden, daß zusätzliche Elektrodenschichten vorgesehen werden. Dies können sowohl Schichten oberhalb der zweiten Elektrodenschicht sein, die zum Beispiel die Leitfähigkeit der zweiten Elektrodenschicht verbessern oder die einer weiteren Verbindungsebene angehören, oder Schichten zwischen der ersten Elektrodenschicht und der zweiten Elektrodenschicht, zum Beispiel dielektrische Schichten zur Bildung eines floatenden Gates.

## Patentansprüche

1. Verfahren zur Herstellung einer integrierten Schaltungsanordnung mit mehreren MOS-Transistoren,
- bei dem auf die Oberfläche eines SOI-Substrats, das mindestens eine monokristalline Siliziumschicht (3) und eine darunter angeordnete, isolierende Schicht (2) umfaßt, ein Gatedielektrikum (4) aufgebracht wird,
- bei dem auf das Gatedielektrikum (4) eine erste Elektrodenschicht (5) aufgebracht wird,
- bei dem die erste Elektrodenschicht (5), das Gatedielektrikum (4) und die monokristaliine Siliziumschicht (3) mit Hilfe einer ersten Maske (6) so strukturiert werden, daß mehrere Mehrschichtstrukturen (7) für mehrere MOS-Transistoren entstehen, die jeweils ein aktives Gebiet für den MOS-Transistor umfassen und um die herum die Oberfläche der isolierenden Schicht (2) freigelegt ist,
- bei dem an den Flanken der Mehrschichtstrukturen (7) erste isolierende Spacer (8) gebildet werden,
- bei dem nach der Bildung der ersten isolierenden Spacer (8) ganzflächig eine zweite Elektrodenschicht (9) aufgebracht wird,
- bei dem mit Hilfe einer zweiten Maske (11) die strukturierte erste Elektrodenschicht (5) und die zweite Elektrodenschicht (9) so strukturiert werden, daß aus der ersten Elektrodenschicht (5) Gateelektroden (12) entstehen und daß aus der zweiten Elektrodenschicht (9) eine Gateleitungsebene (9') entsteht, die die Gateelektroden (12) von mindestens zwei MOS-Transistoren miteinander verbindet,
- bei dem in dem aktiven Gebiet Source/Drain-Gebiete (15, 16) gebildet werden.

2. Verfahren nach Anspruch 1,
bei dem an den Flanken der Gateelektrode (12) vor der Bildung der Source/Drain-Gebiete (15, 16) zweite isolierende Spacer (13) gebildet werden.

3. Verfahren nach Anspruch 2,
bei dem nach der Bildung der zweiten isolierenden Spacer (13) auf der freiliegenden Oberfläche der Siliziumschicht (3) durch selektive Epitaxie Siliziumgebiete (14) aufgewachsen werden.

4. Verfahren nach einem der Ansprüche 1 bis 3,
bei dem nach der Bildung der Mehrschichtstrukturen (7) die strukturierte erste Elektrodenschicht (5) in der Mehrschichtstruktur (7) für mindestens einen MOS-Transistor anders dotiert wird als die übrigen MOS-Transistoren.

5. Verfahren nach einem der Ansprüche 1 bis 4,
- bei dem die erste Elektrodenschicht (5) undotiertes oder dotiertes amorphes oder polykristallines Silizium umfaßt,
- bei dem die zweite Elektrodenschicht (9) mindestens einen der Stoffe amorphes Silizium, polykristallines Silizium, Metallsilizid oder Metall enthält.

## Claims

1. Process for producing an integrated circuit arrangement with a plurality of MOS transistors,
- in which a gate dielectric (4) is applied to the surface of an SOI substrate which comprises at least one monocrystalline silicon layer (3) and an insulating layer (2) arranged thereunder,
- in which a first electrode layer (5) is applied to the gate dielectric (4),
- in which the first electrode layer (5), the gate dielectric (4) and the monocrystalline silicon layer (3) are structured, with the aid of a first mask (6), in such a way as to produce a plurality of multi-layer structures (7) for a plurality of MOS transistors, which each comprise an active region for the MOS transistor and around which the surface of the insulating layer (2) is exposed,
- in which first insulating spacers (8) are formed on the flanks of the multi-layer structures (7),
- in which a second electrode layer (9) is applied over the entire surface after the first insulating spacers (8) have been formed,
- in which the structured first electrode layer (5) and the second electrode layer (9) are structured, with the aid of a second mask (11), in such a way as to produce gate electrodes (12) from the first electrode layer (5) and a gate-line plane (9') from the second electrode layer (9), which connects together the gate electrodes (12) of at least two MOS transistors, and
- in which source/drain regions (15, 16) are formed in the active region.

2. Process according to Claim 1, in which second insulating spacers (13) are formed on the flanks of the gate electrode (12) before the source/drain regions (15, 16) are formed.

3. Process according to Claim 2, in which silicon regions (14) are grown on the exposed surface of the silicon layer (3) by selective epitaxy after the second insulating spacers (13) have been formed.

4. Process according to one of Claims 1 to 3, in which the structured first electrode layer (5) in the multi-layer structure (7) for at least one MOS transistor is doped differently from the other MOS transistors after the multi-layer structures (7) have been formed.

5. Process according to one of Claims 1 to 4,
- in which the first electrode layer (5) comprises undoped or doped amorphous or polycrystalline silicon,
- in which the second electrode layer (9) contains at least one of the substances: amorphous silicon, polycrystalline silicon, metal silicide or metal.

## Revendications

1. Procédé de fabrication d'un montage de circuit intégré qui comporte plusieurs transistors MOS,
- dans lequel on dépose un diélectrique (4) de grille à la surface d'un substrat SOI qui comporte au moins une couche (3) en silicium monocristallin et une couche (2) d'isolement disposée en-dessous,
- dans lequel on dépose sur le diélectrique (4) de grille une première couche (5) d'électrodes,
- dans lequel on structure la première couche (5) d'électrodes, le diélectrique (4) de grille et la couche (3) en silicium monocristallin à l'aide d'un premier masque de telle manière qu'il se forme plusieurs structures (7) multicouches pour des transistors MOS qui comportent chaque fois une région active pour le transistor MOS et qui sont dégagées autour de la surface de la couche (2) d'isolement,
- dans lequel on forme sur les flancs des structures (7) multicouches des premiers espaceurs (8) d'isolement,
- dans lequel on dépose une deuxième couche (9) d'électrodes sur tout la surface après la formation des premiers espaceurs (8) d'isolement,
- dans lequel on structure à l'aide d'un deuxième masque (11) la première couche (5) d'électrodes structurées et la deuxième couche (9) d'électrodes de telle manière qu'il se forme dans la première couche (5) d'électrodes des électrodes (12) de grille et qu'il se forme dans la deuxième couche (9) d'électrodes un plan (9') de conducteur de grille qui relie les unes aux autres les électrodes (12) de grille d'au moins deux transistors MOS,
- dans lequel on forme des régions (15, 16) de source/drain dans la région active.

2. Procédé suivant la revendication 1,
dans lequel on forme sur les flancs de l'électrode (12) de grille, avant la formation des régions (15, 16) de source/drain, des deuxièmes espaceurs (13) d'isolement.

3. Procédé suivant la revendication 2,
dans lequel on fait croître, après la formation des deuxièmes espaceurs (13) d'isolement, sur la surface dégagée de la couche (3) de silicium des régions (14) en silicium par épitaxie sélective.

4. Procédé suivant l'une des revendications 1 à 3,
dans lequel, après la formation des structures (7) multicouches, la première couche (5) d'électrodes structurées est dopée dans la structure (7) multicouche pour au moins un transistor MOS différemment des autres transistors MOS.

5. Procédé suivant l'une des revendications 1 à 4,
- dans lequel la première couche (5) d'électrodes comporte du silicium non dopé ou dopé, amorphe ou polycristallin,
- dans lequel la deuxième couche (9) d'électrodes contient au moins l'un des matériaux : silicium amorphe, silicium monocristallin, siliciure métallique ou métal.
